# EUROPEAN PATENT APPLICATION

(11) **EP 1 014 432 A1**
(43) Date of publication of application: **28.06.2000**
(21) Application number: 99123824.7
(22) Date of filing: 01.12.1999
(51) Int. Cl.: H01L 21/28, H01L 21/316, H01L 29/423

(54) **Method for forming the gate oxide of metal-oxide-semiconductor devices**

(30) Priority: 23.12.1998 US 219988
(71) Applicant: Infineon Technologies North America Corp., San Jose, CA 95112-6000 (US)
(72) Inventor: Vogelsang, Thomas, Williston,VT 05485 (US); Haensch, Wilfried, Midlothian,VA 23113 (US); Faul, Juergen, 01445 Radebeul (DE)
(74) Representative: Patentanwälte Westphal, Mussgnug & Partner

(57) **Abstract**

A method for forming the gate oxide of a Metal-Oxide-Semiconductor (MOS) uses a process sequence of dry, wet and then dry oxidation of a semiconductor. This method results in reduced interface state density at the semiconductor-oxide interface. When n-channel MOS Field Effect Transistors (FETs) are fabricated with the improved process, a reduction in threshold voltage, an increase in electron mobility, an improvement in reverse short channel effects, and an increase in current drive capability are achieved.

## Description

### Field of the Invention

This invention relates to Metal-Oxide-Semiconductor Field Effect Transistors (MOSFETs) that employ silicon oxide as the gate insulator, and more particularly, to a method for making the silicon oxide and to transistors made by such method. Such transistors are also denoted as Insulated Gate Field Effect Transistors (IGFETs).

### Background of the Invention

The field effect transistor that has become the workhorse of the semiconductor industry comprises a semiconductor body (substrate) at whose top surface have been formed a pair of diffused regions (source and drain) of one conductivity type spaced apart by an intermediate region of the substrate which is of the opposite conductivity type. Current flow between electrodes connected to these two spaced apart regions is controlled by an electrode (gate) positioned at a top surface adjacent the intermediate region but insulated electrically therefrom by a thin layer of silicon oxide that is generally formed by oxidizing a surface layer of the intermediate region. In operation, a voltage applied to the gate of sufficient magnitude and appropriate polarity to invert the conductivity type of the intermediate region gives rise to a conductive channel between the two spaced regions in which current flows when a suitable voltage is established by electrode connections to the two spaced apart regions.

It is well known that various parameters of the transistor depend importantly on the properties of the silicon oxide gate insulator formed over the surface of the substrate between the two spaced apart regions that serve as current terminals of the transistor. The parameters include the mobility of carriers flowing in the conductive channel and the threshold voltage needed to invert the conductivity type of the intermediate region of the substrate to form the channel.

Generally this oxide is formed in situ by heating to an appropriate high temperature the silicon substrate in an oxidizing atmosphere, generally either dry (essentially high purity oxygen) or wet (essentially high purity oxygen plus water vapor), for an appropriate period of time. Various growth techniques that have been employed by practitioners of the art have been summarized, for example, in VLSI Technology, Second Edition, S.M. Sze, Editor, McGraw-Hill, 1988, ISBN 0-07-062735-5, page 115.

One problem that arises in a typical oxidation method is that there is introduced at the surface of the silicon substrate a spatially non-uniform distribution of gate oxide interface states. The added interface states decrease undesirably the effective mobility of charge carriers (e.g., electrons in an n-channel field effect transistor). Further, the increase in localized interface states at the source and drain regions worsens the reverse short-channel effect, which is an increase in the threshold voltage for transistors with short channel lengths as compared to the threshold voltage of long channel transistors. Transistors with short channel length would normally be the ones predominantly used in high performance integrated circuits fabricated using the method of gate oxidation of the present invention.

The present invention seeks to improve the mobility and to reduce the reverse short channel effect and thereby to increase the current drive attainable in a sub-micron transistor.

### Summary of the Invention

We have found that the current drive of n-channel sub-micron metal-oxide-semiconductor field effect transistors (MOSFETs) can be improved by a novel process for forming the gate oxide. The novel process is characterized by a combination of dry and wet cycles for the oxidation with appropriate temperatures, time at temperature, and rates of change of temperature. These oxidation conditions have the unexpected effect of improving transistor characteristics.

In one illustrative example in accordance with the present invention, a gate oxide is formed by an oxidation process which comprises a dry cycle during an increase in temperature from 680° to 800°C over about 24 minutes, a wet cycle at 800°C for about 13 minutes, and then a dry cycle during which there is a decrease in temperature from 800° to 780°C over about 8 minutes.

In another illustrative example in accordance with the present invention for forming a gate oxide, there is used a dry cycle during an increase in temperature from 780° to 850°C in about 15 minutes, a wet cycle at 850°C for about 5.5 minutes, and then a dry cycle during the decrease in temperature from 850° to 780°C over a period of about 23 minutes.

In both of these illustrative examples, the increase or decrease of temperature is essentially linear with time.

These two illustrative examples demonstrate that the important factors for the improvement in transistor characteristics are the alternation of dry, wet, and dry oxidation steps, with the dry cycles associated with the periods during which the temperature is being increased or decreased, and the wet cycle associated with the period during which the temperature is maintained at a substantially constant value.

From one aspect, the present invention is directed to a method for forming a gate dielectric layer of an insulated gate field effect transistor formed in a semiconductor body, the method comprising the steps of oxidizing a portion of the semiconductor body using a sequence of dry, wet, and then dry oxidation steps.

The present invention is also directed to a method for forming a gate oxide for use in insulated gate semiconductor devices comprising the steps of placing a semiconductor body in a suitable apparatus designed for oxidizing same, stabilizing the semiconductor body at a temperature at which insignificant oxidation of the body takes place while maintaining the body in an atmosphere consisting of essentially high purity oxygen, increasing the temperature of the body while maintaining the high purity oxygen ambient atmosphere, introducing an atmosphere consisting essentially of high purity oxygen and water vapor, maintaining the body at this temperature and atmosphere for a time sufficient to form a desired thickness of oxide, after sufficient time restoring the atmosphere to the previous ambient consisting of essentially high purity oxygen, and reducing the temperature of the body in a controlled manner to a value at which insignificant oxidation of the body will take place.

The invention will be better understood from the following more detailed description taken in conjunction with the accompanying drawing.

### Brief Description of the Drawing

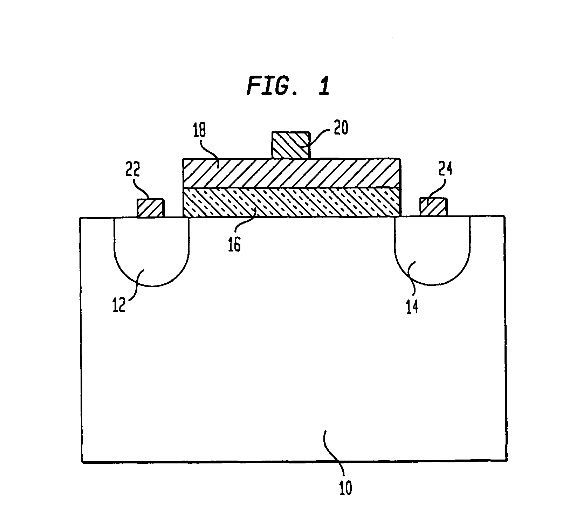

The Figure 1 shows a sectional view of an insulated gate field effect transistor (IGFET) whose gate insulator can be fabricated using the process sequence of the present invention.

### Detailed Description of the Invention

The essence of the present invention is the discovery that improvement in the performance of n-channel Insulated Gate Field Effect Transistors (IGFETs) or Metal-Oxide-Semiconductor Field Effect Transistors (MOSFETs) can be achieved by choosing appropriate parameters and sequences for the oxidation process used to form the gate dielectric, specifically, parameters relating to the time-temperature relationships and ambient atmospheres at specific times and temperatures during the gate oxidation process. By making use of a sequence of multiple, known, oxidation techniques during the gate oxidation process, we have identified a multiple sequence process which results in reduced density of uniformly distributed gate oxide interface states and of interface states localized at the source and drain region of the n-channel transistor. The reduced density of uniformly distributed interface states reduces surface scattering of the carriers and results in improved effective mobility of the carriers. The reduction of localized interface states at source and drain regions results in decreased reverse short channel effects and lowers the threshold voltage in the region of effective channel length where the threshold voltage is higher than that of a long channel field effect transistor. The n-channel transistors in a sub-micron complementary metal-oxide-semiconductor (CMOS) technology are usually designed with a channel length where this lower threshold voltage effect is observed.

The Figure shows a sectional view of an insulated gate field effect transistor (IGFET) having a gate dielectric **16** formed with an oxidation sequence in accordance with the present invention. The transistor is formed in a semiconductor body **10**. A drain region **12** and a source region **14** are separated from eachother by a portion of the semiconductor body **10**. The body **10** is of one conductivity type, for example p-type conductivity, and the drain region **12** and the source region **14** are of the opposite conductivity type, for example, n-type conductivity. The regions where the source and drain are formed are defined by various known masking techniques. The gate dielectric **16** is formed over the region between the source and drain regions **14** and **12**. The present invention is directed to an improved method of forming this gate dielectric **16**. A gate region **18** is formed from a conductive material and is shown contacting a conductive connection **20**. Conductive connections **22** and **24** are shown contacting the drain region **12** and the source region **14**, respectively. The conductive materials and connections may consist of metals, doped silicon or poly-silicon. This transistor can be formed using a self-aligned process with the source and drain regions being self-aligned to the edges of the gate, or by a non-self-aligned process. Field effect transistors formed using either process benefit from the improved method of forming the gate dielectric in accordance with the present invention.

Transistors of the type shown in the Figure were fabricated using a sub-micron Complementary Metal Oxide Semiconductor (CMOS) process, using the oxidation process of the present invention which comprises a sequence of dry and wet oxidation, i.e., a dry oxidation, followed by a wet oxidation, followed by a dry oxidation, to form the gate dielectric (oxide). The transistors were tested and the results compared with transistors fabricated using the same sub-micron CMOS process but with only a prior art dry oxidation process for the gate oxidation.

Uniform interface state density was determined using charge pumping techniques with a 60 micron wide by 0.5 micron long insulated gate field effect transistor. The uniform interface density was found to be decreased by 26%, from 9.0 to 6.7x10¹⁰ per cm², for transistors fabricated using a typical prior art dry gate oxidation versus those fabricated using a dry-wet-dry oxidation sequence in accordance with the present invention.

The saturated threshold voltage of n-channel insulated gate field effect transistors was measured and compared for transistors fabricated using the gate oxidation process sequence of the present invention and a single, prior art, dry oxidation process. It was observed that for effective channel length of about 0.4 micrometer or less, the saturated n-channel threshold voltage of transistors fabricated using either process for forming the gate dielectric decreases, due to short channel effects. For long effective channel length, about 20 micrometer, or greater, the n-channel threshold voltage of transistors fabricated using either process for forming the gate dielectric is the same. For transistors with effective channel length in the range of 0.4 to 1.0 micrometer, the saturated n-channel threshold voltage for transistors fabricated using the prior art dry oxidation process is greater, by as much as 0.05 volt, than that of transistors with long channels. In contrast, for transistors with an effective channel length greater than about 0.4 micrometer, the saturated n-channel threshold voltage is relatively independent of effective channel length for transistors fabricated using the oxidation process sequence of the present invention. This range of effective channel length, about 0.4 to about 1.0 micrometer, is that which would predominantly be used in high performance integrated circuits fabricated using the oxidation process sequence of the present invention.

The effective electron mobility in the same transistors was also measured. The mobility of electrons in transistors fabricated using the oxidation process of the present invention was found to be about 3.5% greater than that of similar transistors fabricated using the prior art dry oxidation process.

The increase in mobility and the reduction of reverse short channel effects both contribute to an increase in the current drive capability of the n-channel transistors fabricated using the oxidation process of the present invention as compared to the current drive capability of n-channel transistors fabricated using the prior art dry oxidation process.

The n-channel saturated current drive capability of the same transistors was also measured. It was observed that for transistors of similar effective channel length, the n-channel transistors fabricated using the oxidation process of the present invention have a saturation current drive capacity 5.5% greater than n-channel transistors fabricated using the prior art dry oxidation process.

No change in the p-channel current drive capability was observed between transistors fabricated using a prior art dry gate oxidation and transistors fabricated using the dry-wet-dry gate oxidation process of the present invention.

In the course of processing additional test circuits which were split between using the dry-wet-dry gate oxidation process of the present invention and using a prior art dry gate oxidation, it was observed that an increase in current drive capability of the n-channel field effect transistors in the range of 5 to 8% could be realized. This 5 to 8% increase in the current drive capability of the n-channel field effect transistors, with no observable change or degradation in the current drive capability of the p-channel field effect transistors, can result in a 2 to 4% or greater increase in circuit performance in circuits fabricated using a CMOS technology.

While the benefit of the gate oxidation process of the present invention on n-channel transistor characteristics was evaluated using a CMOS process with minimum effective channel length of 0.4 micrometer, it is expected that a similar benefit will be observed when the gate oxidation process of the present invention is used with fabrication processes resulting in shorter effective channel lengths.

In one illustrative example in accordance with the present invention, a gate oxide on a semiconductor body is formed by an oxidation process which comprises a dry cycle during an increase in temperature from 680° to 800°C over about 24 minutes, a wet cycle at 800°C for about 13 minutes, and then a dry cycle during which there is a decrease in temperature from 800° to 780°C over about 8 minutes.

A more detailed description of this example is as follows:
place a semiconductor wafer in an oven in an atmosphere of high purity nitrogen with the oven at a temperature of 680°C, wait 30 minutes until the wafer reaches a uniform temperature;
introduce high purity oxygen into the mainly nitrogen atmosphere, wait 15 minutes;
over a period of 30 seconds, change the atmosphere from mainly nitrogen to mainly high purity oxygen;
change the atmosphere to high purity oxygen, over a period of 24 minutes, raise the temperature to 800°C;
over a period of 30 seconds, add hydrogen to the atmosphere;
carry out the wet oxidation process using a period of time sufficient to form a desired thickness of oxide;
over a period of 30 seconds purge the hydrogen from the oven, leaving an atmosphere of high purity oxygen;
introduce high purity nitrogen into the mainly oxygen atmosphere, while over a period of 8 minutes reducing the temperature to 780°C;
over a period of 60 seconds, change the atmosphere to mainly high purity nitrogen;
change the atmosphere to high purity nitrogen, over a period of 45 minutes lower the temperature of the oven to 600°C; and
remove the wafers from the oven.

In a second illustrative example in accordance with the present invention, a gate oxide on a semiconductor body is formed by an oxidation process which comprises a dry cycle during an increase in temperature from 780° to 850°C in about 15 minutes, a wet cycle at 850°C for about 5.5 minutes, and then a dry cycle during the decrease in temperature from 850° to 780°C over a period of about 23 minutes.

In both of these illustrative examples, the increase or decrease of temperature is essentially linear with time.

The oxidation process of the present invention can be used with CMOS technologies that lead to DRAM, logic or combined products, and also discrete MOSFET processes used to fabricate high performance power transistors and IGBIT devices.

The dry-wet-dry gate oxidation process sequence of the present invention is integratable with the other process steps necessary to fabricate either an integrated circuit containing metal-oxide-semiconductor field effect transistors or a discrete device. These process steps include, but are not limited to, the steps necessary to define n-type conductivity wells and p-type conductivity wells (if forming a CMOS circuit), the source and drain regions, the gate electrodes, and conductive connection to the source, drain and gate electrode of the field effect transistor(s). It is recognized that those skilled in the art may substitute other prior art processes and process sequences where appropriate.

The present invention is useful for fabricating self-aligned CMOS FETs. A method of fabricating CMOS FETs in accordance with the present invention comprises the steps of starting with a semiconductor body and forming well regions of first and second conductivity types, defining regions where transistors will be formed in these wells, forming a gate dielectric layer of silicon dioxide in regions over portions of the surface of the semiconductor body using the sequence of dry, wet and then dry oxidation steps of the present invention, forming gate regions over the gate dielectric layer, forming source and drain regions of the second conductivity type in the well of the first conductivity type and forming source and drain regions of the first conductivity type in the well of the second conductivity type, and forming connections to these source, drain and gate regions.

The present invention is also useful for fabricating self-aligned MOSFETs. A method for fabricating self-aligned MOSFETs in accordance with the present invention comprises the steps of starting with a semiconductor body of first conductivity type, defining regions where transistors will be formed, forming a gate dielectric layer of silicon dioxide in these regions over portions of the surface of the semiconductor body using the sequence of dry, wet and then dry oxidation steps of the present invention, forming a gate region over the gate dielectric layer, forming source and drain regions of a second conductivity, where the source and drain regions are defined by the transistor regions and gate regions, and forming electrical connections to the source, drain, and gate regions.

The present invention is also useful for fabricating non-self-aligned MOSFETs. A method for fabricating non-self-aligned MOSFETs in accordance with the present invention comprises the steps of starting with a semiconductor body of a first conductivity type, forming source and drain regions of a second conductivity in the body which are separated by a portion of the body, forming a gate dielectric layer of silicon dioxide over a portion of a surface of the body which separates the source and drain regions using the sequence of dry, wet and then dry oxidation steps of the present invention, forming a gate region over the gate dielectric layer, and forming electrical connections to the source, drain and gate regions.

It is to be understood that the embodiments described are merely illustrative of the invention. Various modifications can be made to it without departing from the spirit and scope of the invention. For example, those skilled in the art will know that existing prior art gate oxidation processes may add additional components to the basic dry or wet oxidizing atmospheres. For, example, hydrogen chloride is one such common additive. It is recognized that such additional components may also be added to the basic oxidizing atmospheres employed in our novel dry-wet-dry sequence for forming gate oxides. This invention was described using the example of n-channel and p-channel field effect transistors fabricated in a sub-micron CMOS process. However, the invention should also be applicable to MOSFET transistors fabricated in a single channel MOS process, to Insulated Gate Bipolar Transistors, and in general to all kinds of devices that make use of the properties of the Metal-Oxide-Semiconductor structure, and whose performance will benefit from reduced interface state density at the silicon-oxide interface.

## Claims

1. A method for forming a gate dielectric layer of an insulated gate field effect transistor formed in a semiconductor body comprising the steps of oxidizing a portion of the semiconductor body using an oxidation sequence of at least one dry oxidation step and one wet oxidation step.

2. The method of claim 1 wherein the oxidation sequence comprises a dry oxidation step, a wet oxidation step and then a dry oxidation step.

3. A method for forming a gate oxide for use in insulated gate semiconductor devices comprising the steps of:
placing a semiconductor body in a suitable apparatus designed for oxidizing same;
stabilizing the semiconductor body at a temperature at which insignificant oxidation of the body takes place, the body being maintained in an atmosphere consisting of essentially high purity oxygen;
increasing the temperature of the body while maintaining the high purity oxygen ambient atmosphere;
introducing an atmosphere consisting essentially of high purity oxygen and water vapor;
maintaining the body at this temperature and atmosphere for a time sufficient to form the desired thickness of silicon dioxide;
after said sufficient time, restoring the atmosphere to the previous ambient consisting of essentially high purity oxygen; and
reducing the temperature of the body in a controlled manner to a value at which insignificant oxidation of the body will take place.

4. The process of claim 3 wherein other trace components or gases are added to the high purity oxygen, and other trace components or gases are added to the high purity oxygen and water vapor.

5. A method for fabricating complementary metal-oxide-semiconductor field effect transistors comprising the steps of:
starting with a semiconductor body forming well regions of first and second conductivity types;
defining regions where transistors will be formed;
forming a gate dielectric layer silicon dioxide in said regions over portions of the surface of said semiconductor body, using a sequence of dry, wet and then dry oxidation steps;
forming gate regions over the gate dielectric layer;
forming source and drain regions of said second conductivity in said well of first conductivity, and forming source and drain regions of said first conductivity in said well of second conductivity; and
forming electrical connections to said source, drain and gate regions.

6. The method of claim 5 wherein the sequence of dry, wet and dry oxidation steps comprises the steps of:
placing the semiconductor body in a suitable apparatus designed for oxidizing same;
stabilizing the body at a temperature at which insignificant oxidation of the body takes place, the body being maintained in an atmosphere consisting of essentially high purity oxygen;
increasing the temperature of the body while maintaining the high purity oxygen ambient atmosphere;
introducing an atmosphere consisting essentially of high purity oxygen and water vapor;
maintaining the body at this temperature and atmosphere for a time sufficient to form a desired thickness of silicon dioxide;
after said sufficient time, restoring the atmosphere to the previous ambient consisting of essentially high purity oxygen; and
reducing the temperature of the body in a controlled manner to a value at which insignificant oxidation will take place.

7. The method of claim 6 wherein other trace components or gases are added to the high purity oxygen, and other trace components or gases are added to the high purity oxygen and water vapor.

8. A method for fabricating a metal-oxide-semiconductor field effect transistor comprising the steps of:
starting with a semiconductor body of first conductivity type, defining regions where transistors will be formed;
forming a gate dielectric layer of silicon dioxide in said regions over portions of the surface of said semiconductor body, using a sequence of dry, wet and then dry oxidation steps;
forming a gate region over the gate dielectric layer;
forming source and drain regions of a second conductivity, said source and drain regions defined by the said transistor regions and gate regions; and
forming electrical connections to said source, drain, and gate regions.

9. The method of claim 8 wherein the sequence of dry, wet and dry oxidation steps comprises the steps of:
placing the semiconductor body in a suitable apparatus designed for oxidizing same;
stabilizing the body at a temperature at which insignificant oxidation of the body takes place, the body being maintained in an atmosphere consisting of essentially high purity oxygen;
increasing the temperature of the body while maintaining the high purity oxygen ambient atmosphere;
introducing an atmosphere consisting essentially of high purity oxygen and water vapor;
maintaining the body at this temperature and atmosphere for a time sufficient to form a desired thickness of silicon dioxide;
after said sufficient time, restoring the atmosphere to the previous ambient consisting of essentially high purity oxygen; and
reducing the temperature of the body in a controlled manner to a value at which insignificant oxidation will take place.

10. The method of claim 9 wherein other trace components or gases are added to the high purity oxygen, and other trace components or gases are added to the high purity oxygen and water vapor.

11. A method for fabricating a metal-oxide-semiconductor field effect transistor comprising the steps of:
starting with a semiconductor body of a first conductivity type, forming source and drain regions of a second conductivity in the body which are separated by a portion of the body;
forming a gate dielectric layer of silicon dioxide over a portion of a surface of the body which separates the source and drain regions using a sequence of dry, wet and then dry oxidation steps;
forming a gate region over the gate dielectric layer; and
forming electrical connections to said source, drain and gate regions.

12. The method of claim 11 wherein the sequence of dry, wet and dry oxidation steps comprises the steps of:
placing the semiconductor body in a suitable apparatus designed for oxidizing same;
stabilizing the body at a temperature at which insignificant oxidation of the body takes place, the body being maintained in an atmosphere consisting of essentially high purity oxygen;
increasing the temperature of the body while maintaining the high purity oxygen ambient atmosphere;
introducing an atmosphere consisting essentially of high purity oxygen and water vapor;
maintaining the body at this temperature and atmosphere for a time sufficient to form a desired thickness of silicon dioxide;
after said sufficient time, restoring the atmosphere to the previous ambient consisting of essentially high purity oxygen; and
reducing the temperature of the body in a controlled manner to a value at which insignificant oxidation will take place.

13. The method of claim 12 wherein other trace components or gases are added to the high purity oxygen, and other trace components or gases are added to the high purity oxygen and water vapor.
